# EUROPEAN PATENT SPECIFICATION

(11) **EP 1 521 297 B1**
(45) Date of publication and mention of the grant of the patent: **02.02.2011**
(21) Application number: 03741183.2
(22) Date of filing: 03.07.2003
(51) Int. Cl.: H01L 21/31, C23C 16/511, H05H 1/46, H01J 37/32

(54) **PLASMA PROCESSING EQUIPMENT**
PLASMAVERARBEITUNGSGERÄT
DISPOSITIF DE TRAITEMENT AU PLASMA

(30) Priority: 05.07.2002 JP 2002197227
(43) Date of publication of application: 06.04.2005
(73) Proprietor: Ohmi, Tadahiro, Sendai-shi, Miyagi 980-0813 (JP); TOKYO ELECTRON LIMITED, Minato-ku Tokyo 107-8481 (JP)
(72) Inventor: OHMI, Tadahiro, Sendai-Shi, Miyagi 980-0813 (JP); HIRAYAMA, Masaki, c/o TOHOKU UNIVERSITY, Sendai-shi, Miyagi 980-8579 (JP); GOTO, Tetsuya, c/o TOHOKU UNIVERSITY, Sendai-shi, Miyagi 980-8579 (JP)
(74) Representative: Liesegang, Eva
(86) International application number: PCT/JP2003/008491
(87) International publication number: WO 2004/006319

(56) References cited:
- EP-A- 1 115 147
- EP-A- 1 376 670
- WO-A1-00/74127
- WO-A1-98/33362
- JP-A- 6 208 952
- JP-A- 11 193 466
- US-B1- 6 357 385

## Description

### TECHNICAL FIELD

The present invention relates to plasma processing apparatuses according to the preamble of claim 1. A plasma processing apparatus of this type is known from EP 1 115 147 A1. Similar prior art is shown in US 6 357 385 B1.

Plasma processing and plasma processing apparatus are indispensable technology for the fabrication of ultrafine semiconductor devices of recent years called deep submicron devices or deep sub-quarter micron devices having a gate length near 0.1 µm or less or for the fabrication of high-resolution flat panel display devices including a liquid crystal display device.

Various methods are used conventionally for exciting plasma in plasma processing apparatuses for use for production of semiconductor devices and liquid crystal display devices. Among others, a parallel-plate type processing apparatus using high-frequency excited plasma or induction-coupled type plasma processing apparatus are used generally. However, these conventional plasma processing apparatuses have a drawback in that plasma formation is not uniform and the region of high electron density is limited. Thus, with such a conventional plasma processing apparatus, it is difficult to achieve a uniform processing over the entire surface of the substrate to be processed with large processing rate and hence with large throughput. It should be noted that this problem becomes particularly serious when processing a large diameter substrate. Further, these conventional plasma processing apparatuses suffer from some inherent problems, associated with its high electron temperature, in that damages are tend to be caused in the semiconductor devices formed on the substrate to be processed. Further, there is caused severe metal contamination caused by sputtering of the processing vessel wall. Thus, with such conventional plasma processing apparatuses, it is becoming more difficult to satisfy the stringent demands for further miniaturization of the semiconductor devices or liquid crystal display devices and further improvement of productivity.
Meanwhile, there has been proposed conventionally a microwave plasma processing apparatus that uses high-density plasma excited by a microwave electric field without using a d.c. magnetic field. For example, there is proposed a plasma processing apparatus having a construction in which a microwave is emitted into a processing vessel from a planar antenna (radial-line slot antenna) having a number of slots arranged to produce a uniform microwave. According to this plasma processing apparatus, plasma is excited as a result of the microwave electric field causing ionization in the gas inside the evacuated vessel. Reference should be made to Japanese Laid-Open Patent Application 9-63793. In the microwave plasma excited according to such a process, it becomes possible to realize a high plasma density over a wide area underneath the antenna, and it becomes possible to conduct uniform plasma processing in short time. Further, because the electron density is low in the microwave plasma thus excited due to the use of microwave for the excitation of the plasma, it becomes possible to avoid damaging or metal contamination of the substrate to be processed. Further, because it is possible to excite uniform plasma over a large area substrate, the foregoing technology can easily attend to the fabrication of semiconductor devices that uses a large-diameter semiconductor substrate or production of large liquid crystal display devices.

### BACKGROUND ART

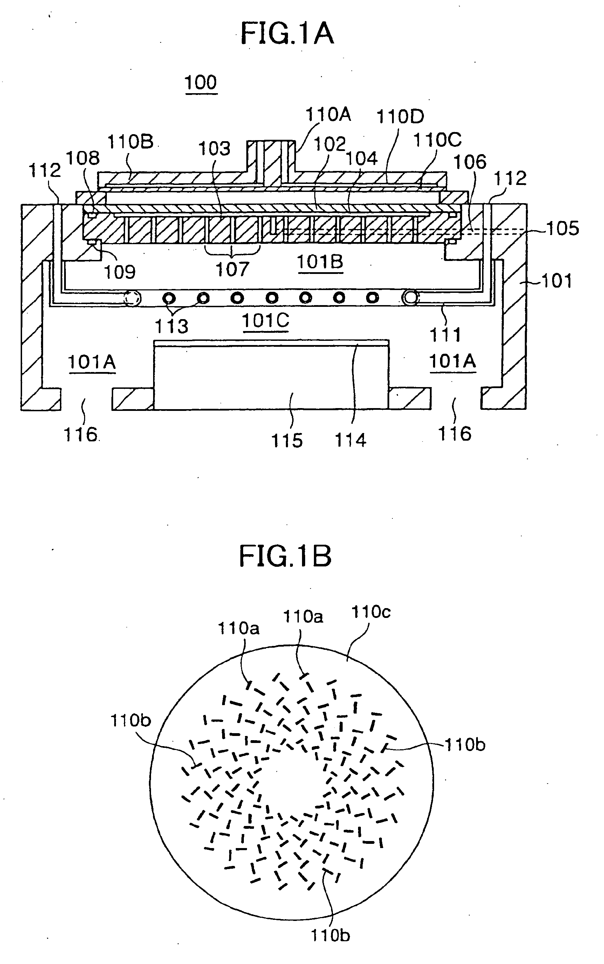

Figures 1A and 1B show the construction of a conventional microwave plasma processing apparatus 100 that uses such a radial line slot antenna, wherein Figure 1A is a cross-sectional view of the microwave plasma processing apparatus 100, while Figure 1B shows the construction of the radial line slot antenna.

Referring to Figure 1A, the microwave plasma processing apparatus 100 has a processing chamber 101 evacuated from plural evacuation ports 116, and a stage 115 that holds a substrate 114 to be processed is formed inside the processing chamber 101. In order to realize uniform evacuation of the processing chamber 101, there is formed a ring-shaped space 101A around the stage 115, wherein the processing chamber 101 can be evacuated uniformly via the space 101A and the evacuation ports 116 by forming the plural evacuation ports 116 in communication with the space 101A with equal interval, in other words, in axial symmetry with regard to the substrate to be processed.

On the processing chamber 101, there is formed a shower plate 103 of low-loss dielectric material with a plate-like form, wherein the shower plate 103 has a number of apertures 107 and is provided via a seal ring 109 as a part of the outer wall of the processing vessel 101 at a location corresponding to the substrate 114 to be processed on the stage 115. Further, a cover plate 102 also of a low loss dielectric material is provided outside the shower plate 103 via another seal ring 108.

On the shower plate 103, there is formed a passage 104 of a plasma gas on the top surface thereof, and each of the plural apertures 107 is formed in communication with the plasma gas passage 104. Further, there is formed a supply passage 108 of the plasma gas inside the shower plate 103 in communication with a plasma gas supplying port 105 provided on the outer wall of the processing vessel 101. Thereby, a plasma gas such as Ar or Kr is supplied to the plasma gas supplying port 105, wherein the plasma gas thus supplied is further supplied to the apertures 107 from the supply passage 108 via the passage 104. The plasma gas is then released into a space 101B right underneath the shower plate 103 inside the processing vessel 101 from the apertures 107 with substantially uniform concentration.

On the processing vessel 101, there is provided a radial line slot antenna 110 having a radiation surface shown in Figure 1B at the outer side of the cover plate 102 with a separation of 4 - 5mm from the cover plate 102. The radial line slot antenna 110 is connected to an external microwave source (not shown) via a coaxial waveguide 110A, and the microwave from the microwave source causes excitation of the plasma gas released into the foregoing spate 101B. Further, the gap between the cover plate 102 and the radiation surface of the radial line slot antenna 110 is filled with the air.

The radial line slot antenna 110 is formed of a flat, disk-like antenna body 110B connected to an external waveguide forming the coaxial waveguide 110A, and a radiation plate 110C is formed at the mouth of the antenna body 110B, wherein the radiation plate 110C is formed with a number of slots 110a and a number of slots 110b perpendicular to the slots 110a. Further, there is interposed a retardation plate 110D of a dielectric plate having a uniform thickness between the antenna body 110B and the radiation plate 110C.

In the radial line slot antenna 110 of such a construction, the microwave supplied from the coaxial waveguide 110 spreads as it travels between the disk-like antenna body 110B and the radiation plate 110C in the radial direction, wherein the retardation plate 110D functions to compress the wavelength thereof. Thus, by forming the slots 110a and 110b concentrically in correspondence to the wavelength of the microwave traveling in the radial direction in a mutually perpendicular relationship, it becomes possible to emit a plane wave having a circular polarization in the direction substantially perpendicular to the radiation plate 110C.

By using such a radial line slot antenna 110, uniform high-density plasma is formed in the space 101B right underneath the shower plate 103. The high-density plasma thus formed has the feature of low electron temperature, and thus, there is caused no damaging in the substrate 114 to be processed. Further, there is caused no metal contamination originating from the sputtering of the chamber wall of the processing vessel 101.

In the plasma processing apparatus 100 of Figure 1, there is further formed with a conductive structure 111 inside the processing vessel 101 between the shower plate 103 and the substrate 114 to be processed, wherein the conductive structure 111 is formed with a large number of nozzles 113 supplied with a processing gas from an external processing gas source (not shown) via a processing gas passage 112 formed in the processing vessel 101, wherein each of the nozzles 113 releases the supplied processing gas to a space 101C between the conductive structure 111 and the substrate 114 to be processed. Thus, the conductive structure 111 functions as a processing gas supplying part. The conductive structure 111 thus constituting the processing gas supplying part is formed with apertures between adjacent nozzles 113 and 113 with a size allowing efficient passage of the plasma formed in the space 101B into the space 101C as a result of diffusion.

Thus, in the case the processing gas is released into the space 101C from the processing gas supplying part 111 via the nozzles 113, the released processing gas undergoes excitation in the processing space 101B by the high-density plasma and there is conducted a uniform plasma processing on the substrate 114 to be processed, efficiently and at high speed, without damaging the substrate and the device structure on the substrate and without contaminating the substrate. On the other hand, the microwave emitted from the radial line slot antenna 110 is blocked by the process gas supplying part 111 formed of a conductor, and thus, there is no risk that the substrate 114 to be processed is damaged.

In the foregoing plasma processing apparatus 100 explained with reference to Figures 1A and 1B, it is important to excite the plasma uniformly with high density in the space 101B right underneath the shower plate 103. For this to be achieved, it is important to ensure that there occurs no plasma excitation in the spaces other than the space 101B, in which the plasma excitation occurs easily, such as the plasma gas passage 104 where the microwave electric field is strong and plasma is tend to be excited or in the foregoing apertures 107.

However, in the case the plasma is actually excited in the present apparatus 10, there is a possibility that the plasma is also excited in the plasma gas passage 104 and further in the apertures 107 depending on the condition of the substrate processing. Once the plasma is excited in the plasma passage 104 or the apertures 107, the microwave power is consumed and the plasma density in the space 101B is decreased. Further, there appears a difference in the plasma density between the region right underneath the apertures 107 and the region far from the apertures 107. Thereby, there arises the problem of non-uniformity in the plasma density over the entire space 101B, which serves for the plasma excitation space.

### DISCLOSURE OF THE INVENTION

Accordingly, it is a general object of the present invention to provide a novel and useful plasma processing apparatus wherein the foregoing problems are eliminated.

Another and more specific object of the present invention is to excite high-density plasma in a desired space with excellent uniformity, without causing plasma excitation in a space in the path for introducing a plasma gas.

The present invention provides a plasma processing apparatus according to claim 1.

According to the present invention, following measures have been taken in the plasma processing apparatus processing a substrate in the purpose of preventing excitation of plasma except for the plasma excitation space used for plasma excitation. In the plasma gas passage, more specifically, the plasma excitation is prevented by using a plasma gas pressure condition set such that there is caused no plasma excitation. For the shower plate from which the plasma gas is radiated, on the other hand, a mechanism that supplies the plasma gas via pores of a porous medium is employed. When the plasma gas is thus supplied via the narrow space of the pores, the electrons accelerated by the microwave collide with the inner wall of the space defining the pore, and the acceleration necessary for causing plasma excitation is not attained for the electrons. With this, the plasma excitation is prevented. As a result, it becomes possible to cause high-density and uniform plasma excitation in a desired plasma excitation space.

Other objects and further features of the present invention will become apparent from the following detailed description of the present invention made hereinafter with reference to the drawings.

### BRIEF DESCRIPTION OF THE DRAWINGS

Figures 1A and 1B are diagrams showing the construction of a conventional microwave plasma processing apparatus that uses a radial line slot antenna;
Figures 2A and 2B are diagrams showing the construction of a microwave plasma processing apparatus according to a first embodiment of the present invention;
Figure 3 is a diagram showing the condition for causing excitation of microwave plasma with regard to the microwave electric field and the pressure of Ar used for the plasma gas;
Figures 4A and 4B are diagrams showing the construction of a processing gas supplying structure according to a second embodiment of the present invention;
Figures 5A and 5B are diagrams showing the construction of a plasma processing apparatus according to a third embodiment of the present invention;
Figures 6A and 6B are diagrams showing the construction of a plasma processing apparatus according to a fourth embodiment of the present invention;
Figures 7A and 7B are diagrams showing the construction of a plasma processing apparatus according to a fifth embodiment of the present invention;
Figures 8A and 8B are diagrams showing the construction of a plasma processing apparatus according to a sixth embodiment of the present invention.

### BEST MODE FOR IMPLEMENTING THE INVENTION

### [FIRST EMBODIMENT]

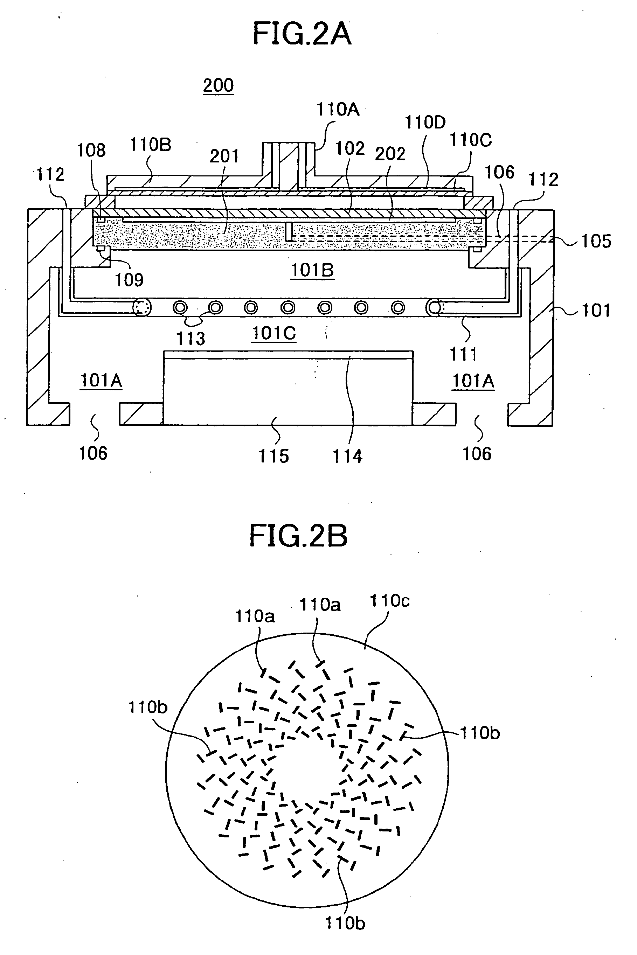

Figures 2A and 2B show the construction of a microwave plasma processing apparatus 200 according to a first embodiment of the present invention, wherein those parts explained previously are designated by the same reference numerals and the description thereof will be omitted.

Referring to Figure 2A, the shower plate 103 of the foregoing microwave plasma processing apparatus 103 is replaced with a disk-like shower plate of a porous medium such as a porous ceramic material formed for example by Al₂O₃ sintered at an ordinary pressure. The shower plate 202 is formed with a passage 202 of the plasma gas on the top surface thereof, wherein the plasma gas of Ar or Kr supplied to the plasma gas supplying port 105 is passed through the plasma gas passage 202 and supplied to the space 101B right underneath the shower plate uniformly through the pores in the porous medium that constitutes the shower plate 202.

As noted before, there is induced a strong microwave electric field in the plasma gas passage 202, and thus, there is a tendency that plasma is excited in such a plasma gas passage 202. Thus, it is necessary to set the pressure of the plasma gas passage 202 to a pressure in which there occurs no excitation of the microwave plasma.

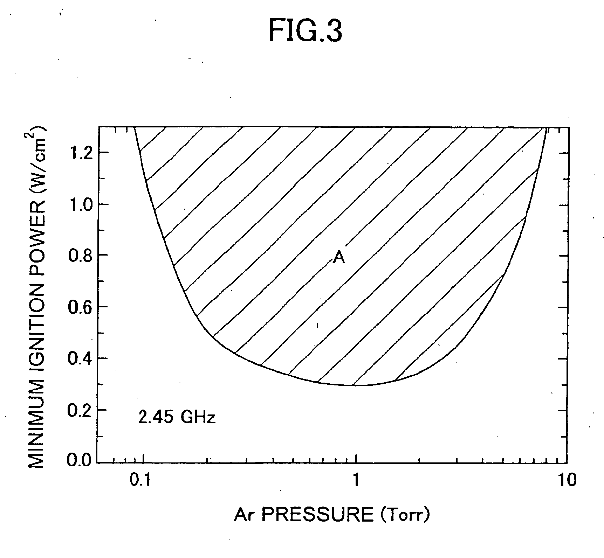

Figure 3 shows the region in which excitation of microwave plasma occurs for the case in which the strength of the microwave electric field and the pressure of Ar used for the plasma excitation gas are changed. In the illustrated example, the frequency of the microwave is set to 2.45GHz. In the drawing, it should be noted that the region designated as region A is the region in which plasma excitation takes place. Thus, excitation of the microwave plasma takes place at the microwave electric field strength and the Ar pressure of the region A.

Referring to Figure 3, there occurs ignition of microwave plasma at the microwave strength of about 0.3W/cm² in the case the pressure is set to about 1 Torr. In this case, the microwave plasma is excited with a near-minimum microwave strength. When the pressure is increased or decreased from 1 Torr, on the other hand, the microwave strength necessary for causing plasma excitation increases, and there appears a condition in which plasma is less easily excited. In the present apparatus, plasma excitation in the plasma gas passage 202 is prevented by setting the pressure of the plasma gas passage to about 6.67kPa - 13.3kPa (about 50 Torr - 100 Torr).

Further, it should be noted that the space 101B used for the plasma excitation space and the plasma gas passage 202, which serves for the plasma gas feeding path, are isolated form each other by the shower plate 201 formed of the porous medium. Thus, the plasma gas is supplied from the plasma gas passage 202 to the foregoing space 101B through the pores of the porous medium forming the shower plate 201. As there exist no sufficiently large space in the pores for causing plasma excitation, there occurs no excitation of plasma in such pores. More specifically, even when there is caused acceleration of electrons in the pores by the microwave, the electrons collide with the wall of the pores before it is accelerated to the degree for causing plasma excitation.

Thus, in the present apparatus 200, there is caused no plasma excitation inside the shower plate 201, which serves for the plasma gas inlet continuous to the space 101B, and it becomes possible to excite high-density plasma uniformly in the space 101B.

### [SECOND EMBODIMENT]

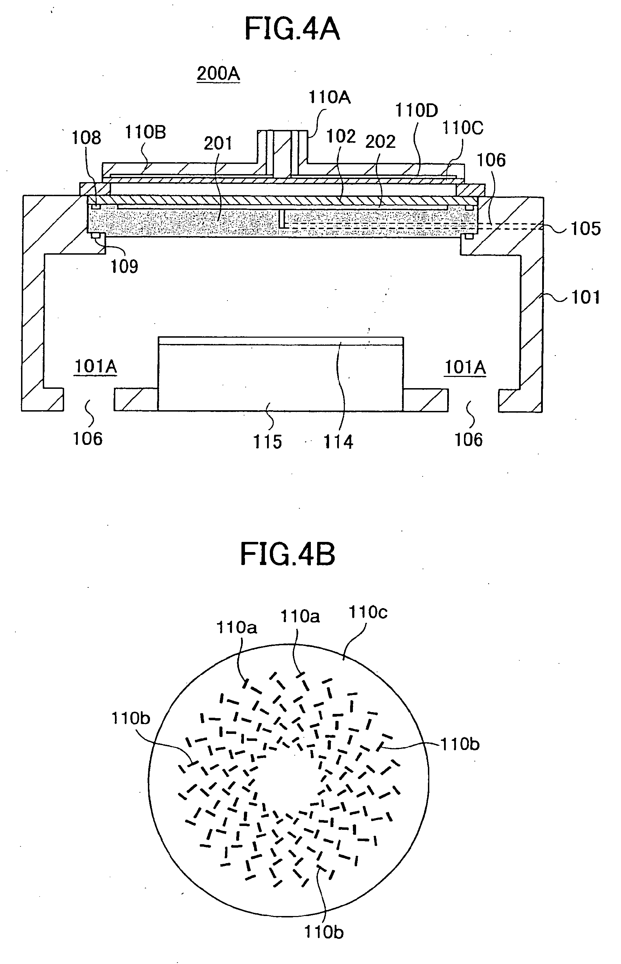

Figures 4A and 4B show the construction of a microwave plasma processing apparatus 200A according to a second embodiment of the present invention, wherein those parts explained previously are designated with the same reference numerals and the description thereof will be omitted.

Referring to Figure 4A, it can be seen that the lower shower plate 111 is removed in the microwave plasma processing apparatus 200A of the present embodiment. Because the lower shower plate 111 is omitted, the apparatus cannot carry out film formation process or etching process by supplying a processing gas separately to the plasma gas. On the other hand, the apparatus can form an oxide film, nitride film or oxynitride film on the surface of the substrate to be processed, by supplying an oxidation gas or nitridation gas from the shower plate 201 together with a plasma gas.

In the present embodiment, too, there occurs no plasma excitation inside the shower plate 201, and it becomes possible to excite high-density and uniform plasma in the space right underneath the shower plate.

### [THIRD EMBODIMENT]

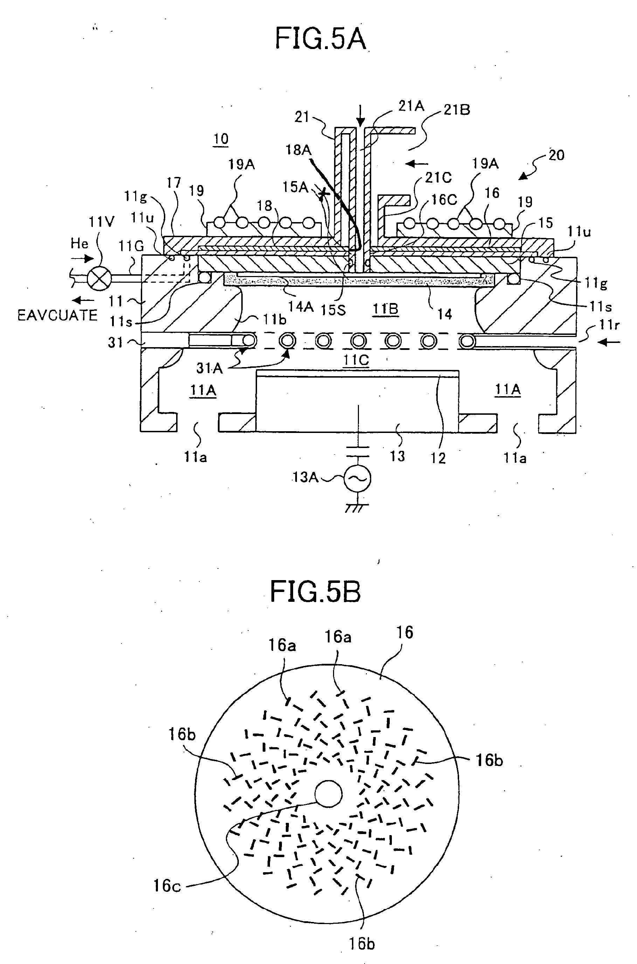

Figures 5A and 5B show the construction of a microwave plasma processing apparatus 10 according to a third embodiment of the present invention.

Referring to Figure 5A, the microwave plasma processing apparatus 10 includes a processing vessel 11 and a stage 13 provided in the processing vessel 11, wherein the stage 13 is formed by hot isotropic pressing process of AlN or Al₂O₃ and holds the substrate 12 to be processed by an electrostatic chuck. In the processing vessel 11, there are formed at least two, preferably three or more evacuation ports 11a in a space 11A surrounding the stage 13 with a uniform interval, and hence in axial symmetry with regard to the substrate 12 to be processed on the stage 13. Thereby, the processing vessel 11 is evacuated by a vacuum pump via such evacuation ports 11a for reducing the pressure therein.

Preferably, the processing vessel 11 is formed of an austenite stainless steel containing Al and a passivation film of aluminum oxide is formed on the inner wall surface thereof by an oxidation processing. Further, there is formed a disk-like shower plate 14 of a porous medium, such as Al₂O₃ sintered at ordinary pressure in the form of porous ceramic material, in a part of the outer wall of the processing vessel corresponding to the substrate 12 to be processed.

The shower plate 14 is mounted on the processing vessel 11, wherein there is provided a cover plate 15 of dense Al₂O₃ formed by HIP processing on the shower plate 14. The Al₂O₃ cover plate 15 thus formed by the HIP process is formed by using Y₂O₃ as a sintering additive and has the porosity of 0.03% or less. This means that the Al₂O₃ cover plate 15 is substantially free from pores or pinholes. Further, the Al₂O₃ cover plate 15 has a very large thermal conductivity for a ceramic, which reaches the value of 30W/mK. Further, sealing of the processing vessel 11 to the environment is achieved by urging the seal ring 11s to the cover plate 15, and thus, there is applied no load to the porous and fragile shower plate 14 in such a structure. The shower plate 14 is formed, in the side thereof that makes contact with the cover plate 15, with a depressed plasma gas passage 14A for causing to flow the plasma gas, wherein the foregoing plasma gas passage 14A is connected to a plasma gas inlet 21A formed in the upper part of the shower plate as will be described.

The shower plate 14 is supported by projections 11b formed on the inner wall of the processing vessel 11, wherein the part of the projection 11b supporting the shower plate 14 is formed to have a rounded surface for suppressing anomalous electric discharge.

Thus, the plasma gas such as Ar or Kr supplied to the plasma gas inlet 21A is supplied to the space 11B right underneath the shower plate uniformly through the pores of the porous medium forming the shower plate 14, after passing through the plasma gas passage 14A inside the shower plate 14. Further, there is inserted a seal ring 15s in the part where the plasma gas inlet 21A and the cover plate 15 engage with each other for confinement of the plasma gas.

Further, a radial line slot antenna 20 is provided on the cover plate 15, wherein the radial line stop antenna 20 includes a disk-shaped slot plate 16 contacting with the cover plate 15 and formed with numerous slots 16a and 16b shown in Figure 5B, a disk-like antenna body 17 holding the slot plate 16, and a retardation plate 18 of a low-loss dielectric material such as Al₂O₃, Si₃N₄, SiON, SiO₂ or the like sandwiched between-the slot plate 16 and the antenna body 17. Further, a plasma gas/microwave inlet part 21 is formed on the upper part of the radial line slot antenna 20. It should be noted that the foregoing plasma gas/microwave inlet 21 part includes a part 21C connected to the antenna body 17 with circular or rectangular cross-section and forming therein a microwave inlet passage, a microwave inlet part 21B of rectangular or circular cross-section, and a plasma gas inlet passage 21A having a generally cylindrical form. Thereby, a plasma gas such as Ar or Kr is supplied to the plasma gas inlet passage 21A. The radial line slot antenna 20 is mounted on the processing vessel 11 via a seal ring 11u, and a microwave of 2.45GHz or 8.3GHz frequency is supplied to the radial line slot antenna from an external microwave source (not shown) connected to the microwave inlet part 21B of the plasma gas/microwave inlet part 21. The microwave thus supplied is emitted into the processing vessel 11 through the cover plate 15 and the shower plate 14 after emitted from the slots 16a and 16b on the slot plate 16 and excites plasma in the plasma gas supplied from the shower plate 14 in the space 11B right underneath the shower plate 14. Thereby, it should be noted that the cover plate 15 and the shower plate 14 are formed of Al₂O₃ and serves for an efficient microwave window. Thereby, the pressure of the plasma gas is maintained to about 6.67kPa - 13.3kPa (about 50 - 100 Torr) in the plasma gas passage 14A for avoiding plasma excitation in the plasma gas passage 14A.

In this case, it should be noted that the foregoing space 11B serving for the plasma excitation space is isolated from the plasma gas passage 14A acting as the passage for supplying the plasma gas, by the shower plate 14 of the porous medium. As noted before, the plasma gas is supplied from the plasma gas passage to the space 11B through the pores in the shower plate 14. Because there is no sufficient space for plasma excitation in the pores, there is caused no plasma excitation.

Because there is caused no plasma excitation in the shower plate 14 serving for the plasma gas inlet passage to the space 11B also in the apparatus 10 of the present embodiment, it becomes possible to excite high-density and uniform plasma in the space 11B. In order to improve intimacy of the radial line slot antenna 20 to the cover plate 15, there is formed a ring-shaped groove 11g on a part of the top surface of the processing vessel 11 that engages with the slot plate 16 in the microwave plasma processing apparatus 10 of the present embodiment. Thus, by evacuating such a groove 11g via an evacuation port 11G communicating therewith, the pressure in the gap formed between the slot plate 16 and the cover plate 15 is reduced. With this, the radial line slot antenna 20 is urged firmly against the cover plate 15 by the atmospheric pressure. It should be noted that such a gap includes not only the slots 16a and 16b formed in the slot plate 16 but also other gaps formed by various reasons. It should be noted that such a gap is sealed by a seal ring 11u provided between the radial line slot antenna 20 and the processing vessel 11.

Further, by filling the gap between the slot plate 16 and the cover plate 15 with an inert gas of low molecular weight via the evacuation port 11G and the groove 11g, it is possible to facilitate heat transfer from the cover plate 15 to the slot plate 16. For such an inert gas, it is preferable to use He having a large thermal conductivity and large ionization energy. In the case of filling the gap with He, it is preferable to set the pressure to about 0.8 atmosphere. In the construction of Figure 3, a valve 11V is connected to the evacuation port 11G for evacuation of the groove 11g and for filling the groove 11g with the inert gas.

The waveguide 21C of the gas/plasma inlet 21 is connected to the disk-shaped antenna body 17, and the plasma gas inlet 21A extends through the opening 18A formed in the retardation plate 18 and the opening 16c formed in the slot plate 16 and is connected to the cover plate opening 15A. Thus, the microwave supplied to the microwave inlet part 21B is emitted from the slots 16a and 16b as it is propagating in the radial direction between the antenna body 17 and the slot plate 16 after passing through the waveguide 21C.

Figure 5B shows the slots 16a and 16b formed on the slot plate 16.

Referring to Figure 5B, the slots 16a are arranged in a concentric relationship, and in correspondence to each of the slots 16a, there is formed a slot 16b perpendicularly thereto, such that the slots 16b are formed also in a concentric relationship. The slots 16a and 16b are formed with an interval corresponding to the wavelength of the microwave compressed by the retardation plate 18 in the radial direction of the slot plate 16, and as a result, the microwave is emitted from the slot plate 16 generally in the form of plane wave. Because the slots 16a and 16b are formed in a mutually perpendicular relationship, the microwave thus emitted form a circular polarization containing two, mutually perpendicular polarization components.

At the center of the slot plate 16, there is formed an opening 16c for insertion of the plasma gas passage 21A.

Further, in the plasma processing apparatus 10 of Figure 5A, a cooling block 19 formed with a cooling water passage 19A is formed on the antenna body 17. Thus, by cooling the cooling block 19 by the cooling water inside the cooling water passage 19A, the heat accumulated in the shower plate 14 is absorbed via the radial line slot antenna 20. The cooling water passage 19A is formed in a spiral form on the cooling block 19, and cooling water, preferably the one in which oxidation-reduction potential is controlled by eliminating dissolved oxygen by means of bubbling of an H₂ gas, is passed through the cooling water passage 19A.

Further, in the microwave plasma processing apparatus 10 of Figure 5A, there is provided a process gas supplying structure 31 having a lattice-shaped process gas passage in the processing vessel 11 between the shower plate 14 and the substrate 12 to be processed on the stage 13, wherein the process gas supplying structure 31 is supplied with a processing gas from a processing gas inlet port 11r provided on the outer wall of the processing vessel and releases the same from a number of processing gas nozzle apertures 31A. Thereby, a desired uniform substrate processing is achieved in the space 11C between the processing gas supplying structure 31 and the substrate 12 to be processed. It should be noted that such a substrate processing includes plasma oxidation processing, plasma nitridation processing, plasma oxynitridation processing, plasma CVD processing, and the like. Further, by supplying a fluorocarbon gas such as C₄F₈, C₅F₈, C₄F₆, and the like or an etching gas containing F or Cl from the processing gas supplying structure 31 and further by applying a high-frequency voltage to the stage 13A from a high-frequency source 13A, it becomes possible to conduct a reactive ion etching process on the substrate 12 to be processed.

According to the microwave plasma processing apparatus 10 of the present embodiment, deposition of reaction byproducts on the inner wall surface of the processing vessel is avoided by heating the outer wall of the processing vessel 11 to the temperature of about 150°C, and continuous and stable operation becomes possible by conducting a dry cleaning process once in a day or so.

### [FOURTH EMBODIMENT]

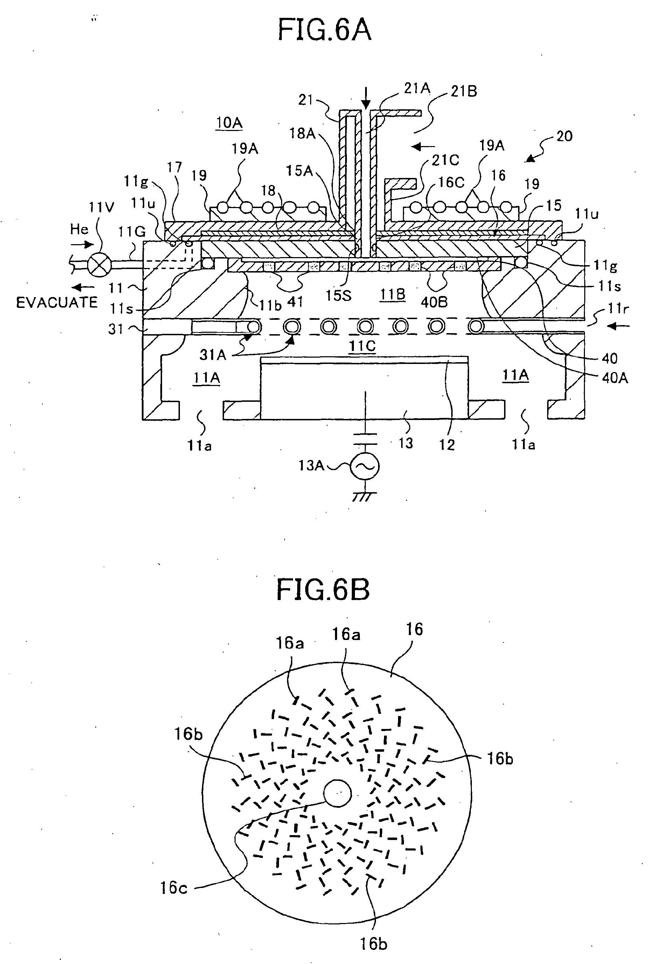

Figure 6A and 6B show an example of a microwave plasma processing apparatus 10A according to a fourth embodiment of the present invention, wherein those parts explained previously are designated by the same reference numerals and the description thereof will be omitted.

Referring to Figure 6A, there is provided a shower plate 40 of dense Al₂O₃ formed by an HIP process and having at least one or more apertures 40B in place of the shower plate 14 of porous medium used for the microwave plasma processing apparatus 10. Further, at the side of the shower plate 40 contacting the cover plate 15, there is formed a plasma gas passage 40A in the form of a depression as the passage of the plasma gas, such that the plasma gas passage 40A communicates each of the apertures 40B. Further, each of the apertures 40B is inserted with a plasma gas inlet component 41 of a porous medium such as a porous ceramic of Al₂O₃ sintered at ordinary pressure. Thereby, the plasma gas of Ar or Kr is supplied to the foregoing space 11B generally uniformly via the pores of the porous medium in the plasma gas inlet component 41, after passing through the plasma gas passage 40A.

In this case, too, there is caused no plasma excitation in the plasma gas passage 40A or plasma gas inlet component 41, similarly to the case of the microwave plasma processing apparatus 10. Thus, it becomes possible to excite high-density and uniform plasma in the space 11B.

### [FIFTH EMBODIMENT]

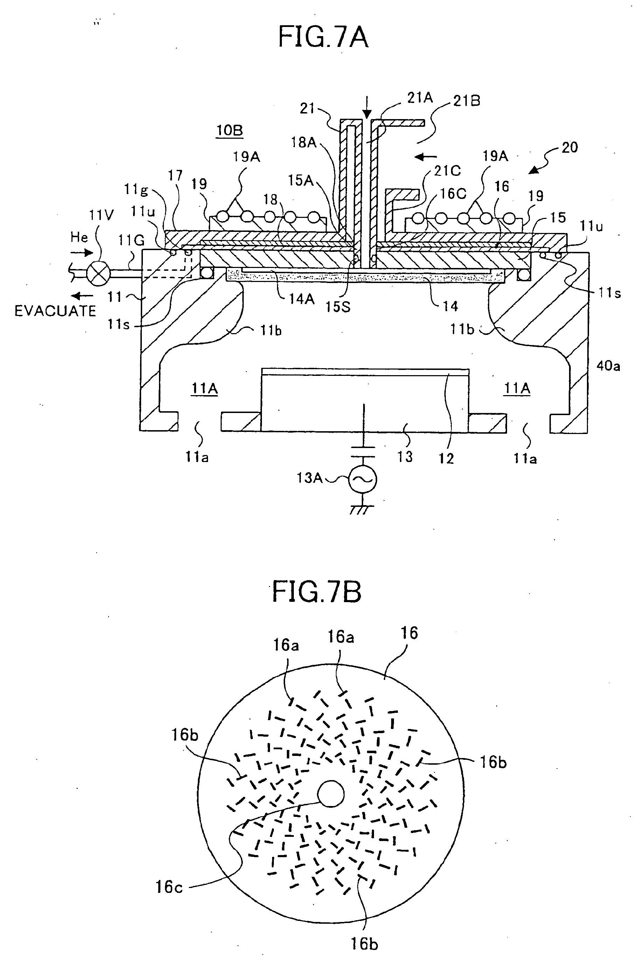

Next, an example of the microwave plasma processing apparatus 10B according to a fifth embodiment of the present invention is shown in Figures 7A and 7B, wherein those parts in the drawings corresponding to the parts described previously are designated by the same reference numerals and the description thereof will be omitted.

Referring to Figure 7A, it will be noted that the lower shower plate 31 is removed in the microwave plasma processing apparatus 10b of the present embodiment. Further, the entire surface of the projections 11b supporting the shower plate 14 is provided with a rounded surface.

Although the plasma processing apparatus 10B of such a construction cannot achieve film formation or etching by supplying a processing gas separately to the plasma gas because of elimination of the lower shower plate 31, it is possible to form an oxide film, a nitride film or an oxynitride film on the surface of the substrate to be processed by supplying an oxidizing gas or nitriding gas from the shower plate 14 together with the plasma gas.

In the present embodiment, too, there is caused no plasma excitation in the plasma gas passage 14A and inside the shower plate 14, and thus, it becomes possible to excite high-density and uniform plasma in the space right underneath the shower plate.

### [SIXTH EMBODIMENT]

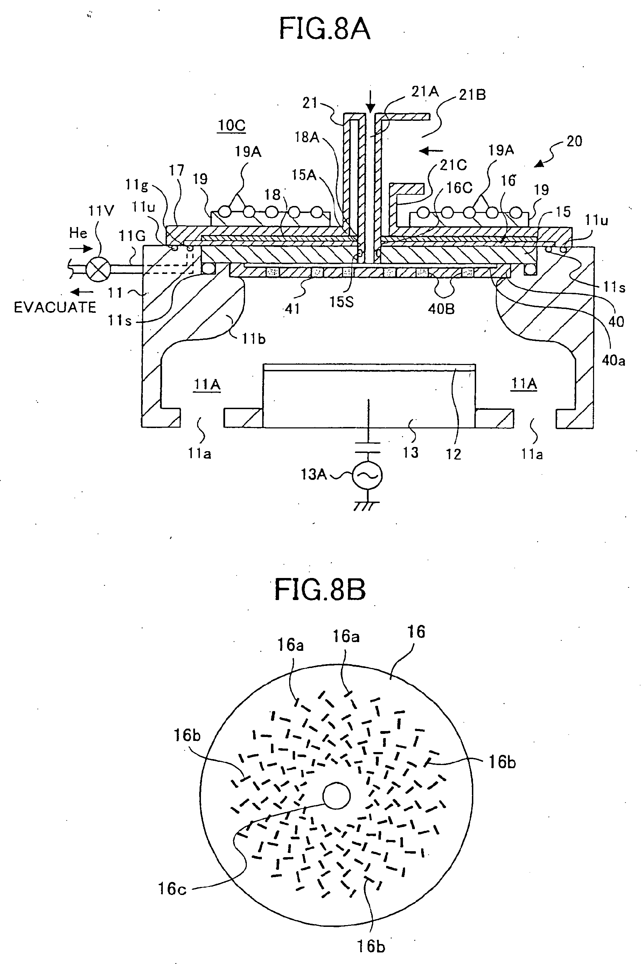

Figures 8A and 8B show an example of a microwave plasma processing apparatus 10C according to a sixth embodiment of the present invention, wherein those parts in the drawings corresponding to the parts explained previously are designated by the same reference numerals and the description thereof will be omitted.

Referring to Figure 8A, a plasma gas of Ar or Kr is supplied to the processing vessel 11 with the microwave plasma processing apparatus 10C of the present embodiment by way of the shower plate 40 of dense Al₂O₃ formed by a HIP process, the shower plate 40 being formed with at least one aperture 40B, and the plasma gas inlet component 41 of a porous medium inserted into the aperture 40B such as a porous ceramic material of sintered Al₂O₃, similarly to the case of the microwave plasma processing apparatus 10C explained previously.

Further, the lower shower plate 31 is eliminated similarly to the case of foregoing apparatus 10B, and the entire surface of the projection 11b holding the shower plate 14 is formed with a rounded surface.

Although the plasma processing apparatus 10B of such a construction cannot achieve film formation or etching by supplying a processing gas separately to the plasma gas because of elimination of the lower shower plate 31, it is possible to form an oxide film, a nitride film or an oxynitride film on the surface of the substrate to be processed by supplying an oxidizing gas or nitriding gas from the shower plate 14 together with the plasma gas.

In the present embodiment, too, there is caused no plasma excitation in the plasma gas passage 40A or in the plasma gas inlet component 41, and thus, it becomes possible to excite high-density and uniform plasma in the space 11B.

Further, while the embodiments heretofore have been explained for the porous ceramic material of Al₂O₃ sintered at ordinary pressure as an example of the porous medium, it should be noted that the present invention is not limited to this material.

### INDUSTRIAL APPLICABILITY

According to the present invention, it becomes possible to excite high-density and uniform plasma in a desired plasma excitation space while suppressing plasma excitation in a plasma gas inlet passage, by separating the space for plasma excitation and the plasma gas inlet passage by a porous medium such as a porous ceramic material in a plasma processing apparatus for processing a substrate.

## Claims

1. A plasma processing apparatus comprising:
a processing vessel (11) provided with a stage (13) for holding a substrate to be processed thereon;
an evacuation system coupled to said processing vessel;
a microwave window provided on said processing vessel; and
a disk-like shower plate (14; 40) for supplying a plasma excitation gas to said processing vessel, said shower plate having a non-concave surface at a side facing the substrate; **characterized in that**
said shower plate (14; 40) includes a porous medium, said shower plate (14; 40) supplying said plasma excitation gas through pores of said porous medium.

2. The plasma processing apparatus as claimed in claim 1, **characterized in that** said shower plate (14) is formed of said porous medium.

3. A plasma processing apparatus comprising:
a processing vessel (11) provided with a stage (13) for holding a substrate to be processed thereon;
an evacuation system coupled to said processing vessel;
a microwave window provided on said processing vessel; and
a shower plate (14; 40) for supplying a plasma excitation gas to said processing vessel, wherein, said shower plate (40) includes therein a plurality of apertures (40B) for ejecting plasma excitation gas there through, said shower plate (40) supplying said plasma gas to an area above said stage through said apertures (40B), **characterized in that** a porous medium is provided in said apertures (40B).

4. The plasma processing apparatus as claimed in claim 3, **characterized in that** said shower plate (40) comprises a dense ceramic.

5. The plasma processing apparatus as claimed in one of the preceding claims, **characterized in that** said microwave window comprises a cover plate (15) constituting a part of an outer wall of said processing vessel (11) wherein said shower plate (14; 40) is provided in intimate contact with said cover plate (15).

6. The plasma processing apparatus as claimed in one of the preceding claims, **characterized in that** said porous medium comprises a sintered ceramic material.

7. The plasma processing apparatus as claimed in one of the preceding claims, **characterized in that** said cover plate (15) comprises a dense ceramic.

8. The plasma processing apparatus as claimed in one of the preceding claims, further comprising a processing gas supplying part (31) between said substrate to be processed and said shower plate (14; 40).

9. The plasma processing apparatus as claimed in claim 8, wherein said process gas supplying part (31) comprises a plasma passage that passes plasma, a processing gas passage connectable to a processing gas source, and plural nozzle apertures communicating with said processing gas passage.

10. The plasma processing apparatus as claimed in one of the preceding claims, further comprising a high frequency source connected to said stage.

11. The plasma processing apparatus as claimed in one of the preceding claims, further comprising a microwave antenna (20) provided on said processing vessel (11) in correspondence to said microwave window, wherein said microwave antenna comprises a radial line slot antenna.

12. A shower plate for a plasma processing apparatus, adapted to provide gas therethrough, said shower plate (40) including therein a plurality of apertures (40B) for supplying said gas therethrough, **characterized in that** a porous medium (41) is provided in said apertures.

13. The shower plate as claimed in claim 12, wherein said shower plate (40) comprises a dense ceramic material.

14. The shower plate as claimed in claim 12 or 13, wherein said porous medium (41) comprises a porous ceramic material.

## Patentansprüche

1. Plasmabehandlungseinrichtung mit folgenden Merkmalen:
ein Behandlungsgefäß (11), das mit einer Plattform (13) zum Halten eines zu behandelnden Substrats ausgestattet ist;
ein Evakuierungssystem, das mit dem Behandlungsgefäß gekoppelt ist;
ein Mikrowellen-Fenster, das an dem Behandlungsgefäß vorgesehen ist; und
eine scheibenartige Duschplatte (14; 40) zum Zuführen eines Plasmaanregungsgases in das Behandlungsgefäß, wobei die Duschplatte eine nicht-konkave Oberfläche auf einer dem Substrat zugewandten Seite hat, **dadurch gekennzeichnet, dass**
die Duschplatte (14; 40) ein poröses Medium umfasst, wobei die Duschplatte (14; 40) das Plasmaanregungsgas durch Poren des porösen Mediums zuführt.

2. Plasmabehandlungseinrichtung nach Anspruch 1, **dadurch gekennzeichnet, dass** die Duschplatte (14) aus dem porösen Medium gebildet ist.

3. Plasmabehandlungseinrichtung mit folgenden Merkmalen:
ein Behandlungsgefäß (11), das mit einer Plattform (13) zum Halten eines zu behandelnden Substrats ausgestattet ist;
ein Evakuierungssystem, das mit dem Behandlungsgefäß gekoppelt ist;
ein Mikrowellen-Fenster, das an dem Behandlungsgefäß vorgesehen ist; und
eine Duschplatte (14; 40) zum Zuführen eines Plasmaanregungsgases in das Behandlungsgefäß, wobei die Duschplatte (14) mehrere Öffnungen (40B) zum Ausstoßen von Plasmaanregungsgas durch diese hindurch aufweist, wobei die Duschplatte (40) das Plasmagas in einen Bereich oberhalb der Plattform durch diese Öffnungen (40B) hindurch zuführt, **dadurch gekennzeichnet, dass** ein poröses Medium in den Öffnungen (40B) vorgesehen ist.

4. Plasmabehandlungseinrichtung nach Anspruch 3, **dadurch gekennzeichnet, dass** die Duschplatte (40) eine dichte Keramik umfasst.

5. Plasmabehandlungseinrichtung nach einem der vorangehenden Ansprüche, **dadurch gekennzeichnet, dass** das Mikrowellen-Fenster eine Deckplatte (15) umfasst, die einen Teil einer Außenwand des Behandlungsgefäßes (11) bildet, wobei die Duschplatte (14; 40) in engem Kontakt mit der Deckplatte (15) vorgesehen ist.

6. Plasmabehandlungseinrichtung nach einem der vorangehenden Ansprüche, **dadurch gekennzeichnet, dass** das poröse Medium ein gesintertes Keramikmaterial umfasst.

7. Plasmabehandlungseinrichtung nach einem der vorangehenden Ansprüche, **dadurch gekennzeichnet, dass** die Deckplatte (15) eine dichte Keramik umfasst.

8. Plasmabehandlungseinrichtung nach einem der vorangehenden Ansprüche, mit ferner einem Prozessgas-Zuführteil (31) zwischen dem zu behandelnden Substrat und der Duschplatte (14; 40).

9. Plasmabehandlungseinrichtung nach Anspruch 8, wobei der Prozessgas-Zuführteil (31) einen Plasmadurchgang, welcher Plasma hindurch lässt, einen Prozessgas-Durchgang, der mit einer Prozessgas-Quelle verbindbar ist, und mehrere Düsenöffnungen, die mit dem Prozessgas-Durchgang in Verbindung stehen, aufweist.

10. Plasmabehandlungseinrichtung nach einem der vorangehenden Ansprüche mit ferner einer Hochfrequenzquelle, die mit der Plattform verbunden ist.

11. Plasmabehandlungseinrichtung nach einem der vorangehenden Ansprüche, mit ferner einer Mikrowellenantenne (20), die an dem Behandlungsgefäß (11) in Übereinstimmung mit dem Mikrowellen-Fenster vorgesehen ist, wobei die Mikrowellenantenne eine Radial-Schlitzantenne umfasst.

12. Duschplatte für eine Plasmabehandlungseinrichtung, die dazu eingerichtet ist, Gas durchzuführen, wobei die Duschplatte (40) mehrere Öffnungen (40B) zum Zuführen von Gas durch diese hindurch aufweist, **dadurch gekennzeichnet, dass** ein poröses Medium (41) in den Öffnungen vorgesehen ist.

13. Duschplatte nach Anspruch 12, wobei die Duschplatte (40) ein dichtes Keramikmaterial umfasst.

14. Duschplatte nach Anspruch 12 oder 13, wobei das poröse Medium ein poröses Keramikmaterial umfasst.

## Revendications

1. Dispositif de traitement par plasma, comprenant :
une enceinte de traitement (11) munie d'une plate forme (13) pour tenir un substrat à traiter ;
un système d'évacuation couplé à l'enceinte de traitement ;
une fenêtre pour micro-ondes prévue sur l'enceinte de traitement ; et
une plaque à doucher en forme de disque (14 ; 40) pour la fourniture d'un gaz à excitation en plasma à l'enceinte de traitement, la plaque à doucher ayant une surface non-concave sur le côté opposé au substrat ; **caractérisé en ce que**
la plaque à doucher (14 ; 40) comprend un milieu poreux, la plaque à doucher (14 ; 40) fournissant le gaz à excitation en plasma par les pores du milieu poreux.

2. Dispositif de traitement par plasma selon la revendication 1, **caractérisé en ce que** la plaque à doucher (14) est formée en un milieu poreux.

3. Dispositif de traitement par plasma comprenant :
une enceinte de traitement (11) munie d'une plateforme (13) pour tenir un substrat à traiter ;
un système d'évacuation couplé à l'enceinte de traitement ;
une fenêtre pour micro-ondes prévue sur l'enceinte de traitement ; et
une plaque à doucher (14 ; 40) pour fournir un gaz à excitation en plasma à l'enceinte de traitement, la plaque à doucher (40) comprenant une pluralité d'ouvertures (40B) pour éjecter un gaz à excitation en plasma, la plaque à doucher (40) fournissant le gaz de plasma par les ouvertures (40B) à une zone située au-dessus de la plateforme, **caractérisé en ce qu'**un milieu poreux est prévu dans les ouvertures (40B).

4. Dispositif de traitement par plasma selon la revendication 3, **caractérisé en ce que** la plaque à doucher (40) comprend une céramique dense.

5. Dispositif de traitement par plasma selon l'une quelconque des revendications précédentes, **caractérisé en ce que** la fenêtre pour micro-ondes comprend une plaque couvercle (15) constituant une partie d'une paroi extérieure de l'enceinte de traitement (11), la plaque à doucher (14 ; 40) étant prévue en contact intime avec la plaque couvercle (15).

6. Dispositif de traitement par plasma selon l'une quelconque des revendications précédentes, **caractérisé en ce que** le matériau poreux comprend un matériau de céramique frittée.

7. Dispositif de traitement par plasma selon l'une quelconque des revendications précédentes, **caractérisé en ce que** la plaque couvercle (15) comprend une céramique dense.

8. Dispositif de traitement par plasma selon l'une quelconque des revendications précédentes, comprenant en outre une partie d'alimentation en gaz de traitement (31) entre le substrat à traiter et la plaque à doucher (14 ; 40).

9. Dispositif de traitement par plasma selon la revendication 8, dans lequel la partie d'alimentation en gaz de traitement (31) comprend un passage de plasma qui laisse passer du plasma, un passage de gaz de traitement connectable à une source de gaz de traitement, une pluralité d'ouvertures servant de buses communiquant avec le passage de gaz de traitement.

10. Dispositif de traitement par plasma selon l'une quelconque des revendications précédentes, comprenant en outre une source de haute fréquence connectée à ladite plateforme.

11. Dispositif de traitement par plasma selon l'une quelconque des revendications précédentes, comprenant en outre une antenne à micro-ondes (20) prévue sur l'enceinte de traitement (11) en correspondance avec la fenêtre pour micro-ondes, l'antenne à micro-ondes comprenant une antenne à fentes linéaires radiales.

12. Plaque à doucher pour un dispositif de traitement par plasma, adaptée à fournir un gaz, la plaque à doucher (40) comprenant une pluralité d'ouvertures (40B) pour fournir le gaz à travers, **caractérisée en ce qu'**un milieu poreux (41) est prévu dans lesdites ouvertures.

13. Plaque à doucher selon la revendication 12, la plaque à doucher (40) comprenant un matériau de céramique dense.

14. Plaque à doucher selon la revendication 12 ou 13, dans laquelle le milieu poreux (41) comprend un matériau de céramique poreuse.
